# EUROPEAN PATENT APPLICATION

(11) **EP 4 769 951 A1**
(43) Date of publication of application: **01.07.2026**
(21) Application number: 25225553.4
(22) Date of filing: 19.12.2025
(51) Int. Cl.: H04B 1/00, H03F 3/189, H04B 1/04

(54) **ELECTRONIC SYSTEMS AND MODULES WITH RECONFIGURABLE DEVICES AND METHODS OF OPERATION**

(30) Priority: 24.12.2024 US 202419000774
(71) Applicant: NXP USA, Inc., Austin, TX 78735 (US)
(72) Inventor: HOIRUP, Carsten, 5656AG Eindhoven (NL)
(74) Representative: Schwarzweller, Thomas

(57) **Abstract**

An electronic module includes an electronic circuit and a controller circuit. The electronic circuit includes first and second reconfigurable devices, each with an electronic component that is capable of being configured into a plurality of states. The controller circuit includes an external control signal interface that receives encoded state information, and an enable signal input that receives an enable signal indicating whether the electronic circuit is in an active or inactive operational mode. After the controller circuit has received the encoded state information, and the enable signal indicates that the electronic circuit has transitioned from the active operational mode into the inactive operational mode, the controller circuit sends the encoded state information through an internal control signal interface to the reconfigurable devices. The encoded state information causes the reconfigurable devices to configure their electronic components into component states that correspond to the selected circuit state.

## Description

### TECHNICAL FIELD OF THE INVENTION

The present invention relates generally to electronic modules that include reconfigurable devices, and more particularly relates to apparatus and methods for synchronizing reconfiguration of such reconfigurable devices during inactive operational intervals.

### BACKGROUND OF THE INVENTION

A phased array antenna for a cellular base station may include numerous front end power amplifier modules (e.g., 64, 128, 256, or more) in a single array. In such an array, each power amplifier module includes a transmitter with a front end power amplifier configured to amplify a radio frequency (RF) signal for transmission over the air interface. Each front end power amplifier is controlled by a front end processor, typically through a serial communications interface and additional input-output (IO) lines.

The serial communications interface may be used to transfer information that is not real-time critical. Conversely, the additional IO lines may convey other signals that are real-time critical, such as an enable signal. In a time division duplex (TDD) communications system, for example, transitions in the enable signal may correspond to transitions between time intervals when the system is transmitting RF signals ("transmit time intervals"), and time intervals when the system is receiving RF signals ("receive time intervals"). Transitions in the enable signal may cause the power amplifier modules to turn their power amplifiers on during the transmit time intervals, and to turn their power amplifiers off during the receive (or other non-transmit) time intervals.

Certain changes to the configuration of a power amplifier within a power amplifier module should be made during non-transmit time intervals in order to avoid creating errors or distortions in the RF signal. In some systems, the non-transmit time intervals may be very short. As power amplifier designs become more complex, designers are challenged to create interfaces and amplifier control methods that can implement configuration changes within the non-transmit time intervals.

### BRIEF DESCRIPTION OF THE DRAWINGS

The accompanying figures in which like reference numerals refer to identical or functionally similar elements throughout the separate views, the figures are not necessarily drawn to scale, and which together with the detailed description below are incorporated in and form part of the specification, serve to further illustrate various embodiments and to explain various principles and advantages all in accordance with the present invention.
FIG. 1 is a diagram of a front end of a communications system, according to one or more embodiments;
FIG. 2 is a diagram of a power amplifier module, according to one or more embodiments;
FIG. 3 is a schematic of a Doherty power amplifier that includes reconfigurable devices, according to one or more embodiments;
FIG. 4 is a simplified diagram of a reconfigurable device, according to one or more embodiments;
FIG. 5 is a flowchart of a method for a front end processor circuit to initiate configuration changes to a power amplifier module, according to one or more embodiments;
FIG. 6 is a flowchart of a method for a power amplifier module to reconfigure devices within the module, according to one or more embodiments;
FIG. 7 is an example of a reconfigurable device state table, according to one or more embodiments;
FIG. 8 is a first timing diagram that depicts timing for making synchronized configuration changes to reconfigurable devices, according to one or more embodiments; and
FIG. 9 is a second timing diagram that depicts timing for making synchronized configuration changes to reconfigurable devices, according to one or more embodiments.

### DETAILED DESCRIPTION

Embodiments of the inventive subject matter include electronic modules, and more specifically, power amplifier modules, which include "reconfigurable" devices that may be controlled to optimize the performance of the circuitry housed within those modules. As used herein, a "reconfigurable device" is an electronic component or circuit that may be configured into any of multiple states at any given time, where a "state" may correspond to a component value, a switch state, or another controllable electrical characteristic. For example, in the context of the below-described embodiments, some reconfigurable devices discussed herein may include dynamic signal splitters, tuners, variable passive components (e.g., variable capacitors, inductors, resistors), and switches. The various embodiments of the inventive subject matter may be used in systems with other types of reconfigurable electronic components and circuits, as well.

When such reconfigurable devices are incorporated into the transceivers of a cellular base station that supports phased array communications, and more particularly into transmitter power amplifier modules of those transceivers, several design challenges present themselves. One challenge relates to establishing a communication infrastructure and protocol within the cellular base station that enables a front end processor circuit to cause the reconfigurable devices to change their states (i.e., to be reconfigured). As mentioned above, a phased array antenna for a cellular base station may include numerous front end power amplifier modules (e.g., 64, 128, 256, or more) in a single array. When new reconfigurable devices are incorporated into each of these modules, a communications infrastructure needs to be established for the devices to receive configuration and control information, such as state information corresponding to a particular circuit state of a plurality of possible circuit states. However, adding additional communications and control lines between each new device and the front end processor circuit would make the communications infrastructure significantly more complex and expensive. For example, if a single new reconfigurable device were added to each transmitter power amplifier module of a 256 element phased array system, direct serial communications (e.g., for communicating configuration or other information) between the new reconfigurable devices and the front end processor circuit may require at least 256 x *N* new serial communications lines (where *N* is the number of lines used to support the serial communication protocol). Additional IO lines also may be added for each module for real-time control. If multiple new reconfigurable devices were added to each module, the numbers of new serial communications and IO lines would be multiplied by the number of new reconfigurable device added to the module.

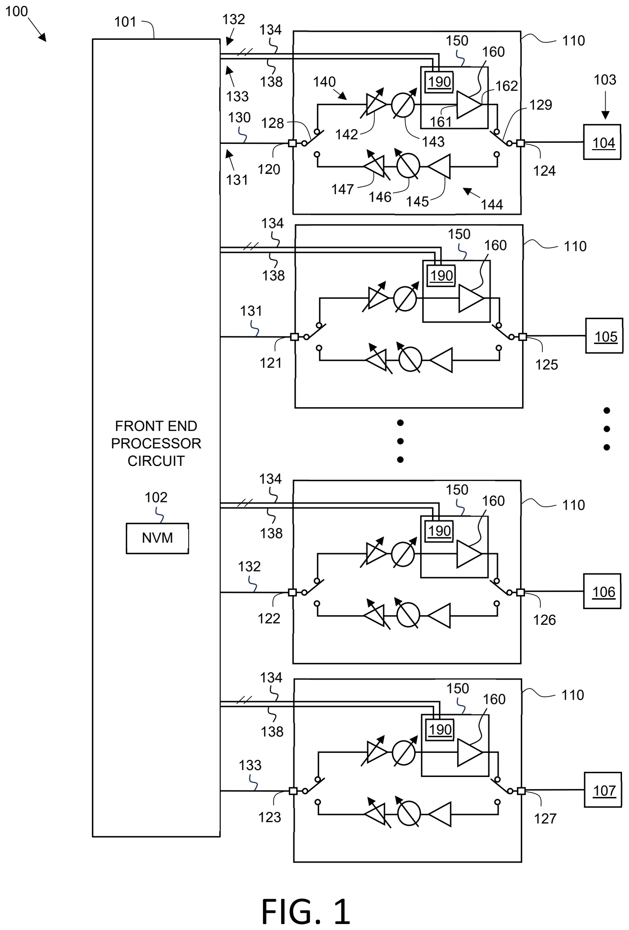

Embodiments of the inventive subject matter address this issue by providing a serial communications infrastructure that does not require an increase in the number of serial communications lines and IO lines between the front end processor circuit and the transmitter power amplifier modules, even though a number of new reconfigurable devices are added to the transmitter power amplifier modules. As will be discussed in detail below, this is achieved by including a controller circuit (e.g., circuit 190, FIGs 1-3) within each power amplifier module (e.g., modules 150-153, FIGs 1-3), which has a first (external) control signal interface coupled to the front end processor circuit (e.g., circuit 101, FIG. 1), and a second (internal) control signal interface coupled to the one or more reconfigurable devices within the module (e.g., devices 263, 297-1 through 297-4, 367, 370, 373, 388, FIGs 1-3), according to one or more embodiments. Essentially, rather than having direct serial connections between the front end processor circuit and the reconfigurable devices, the front end processor circuit communicates reconfiguration information (referred to below as encoded state information) to the controller circuits of the modules over the external control signal interface, and the controller circuits communicate the reconfiguration information to the reconfigurable devices over the internal control signal interface and, in some embodiments, additional IO lines. This has the significant technical advantage of enabling the front end processor circuit to initiate configuration changes of the reconfigurable devices in the power amplifier modules without the need for new serial communications lines and IO lines between the front end processor circuit and the reconfigurable devices. Thus, increases in system cost, complexity, and size may be substantially avoided, despite adding new adjustability (e.g., new reconfigurable devices) to the power amplifier modules.

Another challenge associated with adding reconfigurable devices to the transmitter power amplifier modules relates to timing constraints associated with reconfiguring those devices during operation of the system. Specifically, the reconfigurable devices should be reconfigured during time intervals when the transmitter power amplifier module is not transmitting (e.g., during receive or idle time intervals). Further, the reconfiguration process (and subsequent circuit settling) should be completed before the next transmit time interval commences. In a time division duplex (TDD) communication system, the duration of time between transmit time intervals may be as short as a single OFDM (Orthogonal Frequency Division Multiplexing) symbol interval (e.g., on the order of about 17 microseconds in some systems, although the duration of time between transmit time intervals may be less or more, in other systems).

Embodiments of the inventive subject matter address this issue by providing parallel communications between the controller circuit and the multiple reconfigurable devices of a transmitter power amplifier module in order to convey device configuration information. Further, the device configuration information may be conveyed using compact encoded state information, according to one or more embodiments. Each reconfigurable device may correlate received encoded state information with entries in a look up table (stored within the device) to determine a new device state for the reconfigurable device. Utilizing parallel communications, the above-described encoded state information and look up tables enable reconfiguration information to be exchanged between the controller circuit and each reconfigurable device using very little data, thus shortening the amount of time that is utilized for communicating this reconfiguration information to the reconfigurable devices.

The methodology for communicating the reconfiguration information to the reconfigurable devices has the technical advantage of ensuring that a reconfiguration processes may be performed and completed within a potentially short period of time (e.g., the duration of time between adjacent transmit time intervals), regardless of the number of reconfigurable devices that need to be reconfigured. Said another way, the communications associated with reconfiguring the reconfigurable devices may be performed during relatively-short durations of time between transmit time intervals, allowing for additional time for the reconfigurable devices to implement the configuration changes, and further allowing time for the circuit to "settle" after making the configuration changes. Essentially, the various embodiments described herein enable changes to the configurations of reconfigurable devices within an electronic module (e.g., a transmitter power amplifier module) to be made while the module is in an "inactive operational mode" (e.g., during a non-transmit time interval), thus avoiding the creation of errors or distortions in the RF signal that otherwise may have occurred if such reconfigurations were performed while the module is in an "active operational mode" (e.g., during a transmit time interval).

FIG. 1 is a diagram of a front end of a communications system 100 (or more generically, an "electronic system"), according to one or more embodiments. For example, the communication system 100 may be a cellular communications system (e.g., a 4G, 5G, or 6G communications system), which communicates over the air interface using a phased array antenna 103. The phased array antenna 103 includes a number, *N*, of antenna elements (e.g., antenna elements 104-107) arranged in an array. For example, *N* may be 64, 128, 256, or some other value. Although only four antenna elements 104-107 are depicted in FIG. 1, the ellipses between elements 105 and 106 indicate that more antenna elements are present.

System 100 also includes a front end processor circuit 101, and a number, *N*, of transceivers 110, which are electrically connected between the processor circuit 101 and the antenna elements 104-107. The equal number of transceivers 110 and antenna elements 104-107 shown in FIG. 1 indicates that the antenna elements 104-107 are single polarized, and a single transceiver 110 is coupled to each antenna element 104-107. In alternate embodiments, the antenna elements may be dual polarized, and two transceivers 110 may be coupled to perpendicular sides of each antenna element 104-107. In such embodiments, the system 100 may include *N* transceivers 110 and *N*/*2* antenna elements 104-107.

The front end processor circuit 101 includes a plurality of electronic module interfaces, where each electronic module interface includes, among other things, a signal input/output (IO) terminal 131 that is coupled through a transmission line 130 to a processor-side, signal IO terminal 120-123 of a transceiver 110. In addition, each electronic module interface includes a control signal interface 132 that is coupled to each transceiver 110 through a communications bus 134 (e.g., a serial communications bus), and one or more additional IOs 133 that are coupled to each transceiver 110 through one or more transmission lines 138. According to one or more embodiments, and as will be described in more detail later, the processor circuit 101 may convey non-real-time information to the transceivers 110 through the control signal interface and the communications bus 134, and may convey real-time information to the transceivers 110 through the additional IO transmission line(s) 138.

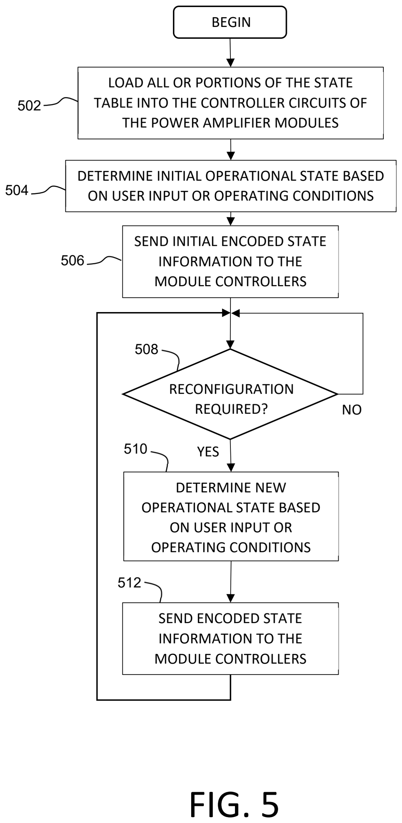

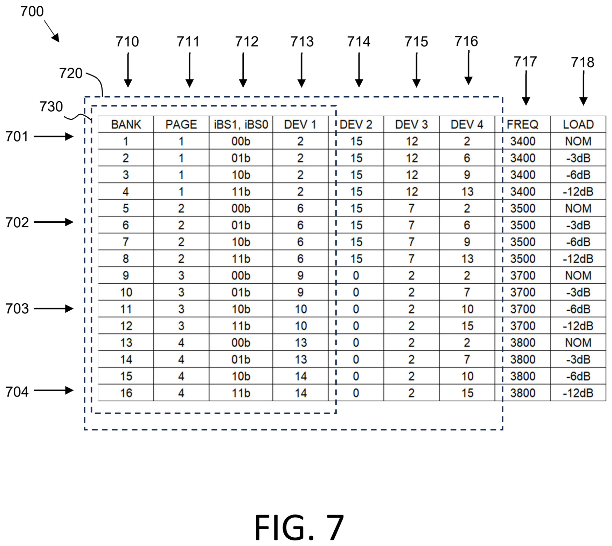

The front end processor circuit 101 is configured to produce analog RF signals for transmission by the transceivers 110. In addition, the front end processor circuit 101 is configured to receive RF signals from the transceivers 110, and to process those receive signals. According to one or more embodiments, the front end processor circuit 101 includes a data storage structure, such as a non-volatile memory (NVM) 102 ("controller circuit data storage structure"). Various data may be stored in the NVM 102 to facilitate the functions performed by the front end processor 101. For example, according to some embodiments, and as will be described in more detail later in conjunction with FIG. 5, the data stored in NVM 102 may include a state table (e.g., state table 700, FIG. 7), which the processor circuit 100 may access to determine desired operational states for the transceivers 110.

The transceivers 110 may be configured to operate using time division duplexing (TDD), according to one or more embodiments. Accordingly, each transceiver 110 may include a processor-side, signal I) terminal 120-123 (as mentioned above), an antenna-side, signal IO terminal 124-127, a transmitter lineup 140 coupled between a processor-side, signal IO terminal 120-123 and an antenna-side IO terminal 124-127, and a receiver lineup 144 coupled in parallel with the transmitter lineup 140 between the processor-side, signal IO terminal 120-123 and the antenna-side IO terminal 124-127. More specifically, an input to each transmitter lineup 140 is coupled to one of the processor-side, signal IO terminals 120-123, and an output to each transmitter lineup 140 is coupled to one of the antenna-side, signal IO terminals 124-127. Conversely, an input to each receiver lineup 144 is coupled to one of the antenna-side, signal IO terminals 124-127, and an output to each receiver lineup 144 is coupled to one of the processor-side, signal IO terminals 120-123.

To facilitate operation using TDD, each transceiver 110 also may include first and second switching elements 128, 129. Each of the first and second switching elements 128, 129 may be, for example, a single pole, double throw switch. Switching element 128 may include a common first terminal (pole) coupled to a processor-side, signal IO terminal 120-123, a second terminal coupled to the input to a transceiver lineup 140, and a third terminal coupled to the output of a receiver lineup 144. Switching element 129 may include a common first terminal (pole) coupled to an antenna element 104-107 through an antenna-side, signal IO terminal 124-127, a second terminal coupled to the output of a transceiver lineup 140, and a third terminal coupled to the input of a receiver lineup 144.

To implement TDD operation, the processor circuit 101 may send simultaneous control signals to the first and second switching elements 128, 129 of all of the transceivers 110. At some points in time, the processor circuit 101 may cause all of the switching elements 128, 129 of all of the transceivers 110 simultaneously to complete a circuit between the processor-side and antenna-side IO terminals 120-123, 124-127 through the transmitter lineups 140. When the system 100 is actively conveying RF signals through the transmitter lineups 140 in this system configuration (e.g., the transmit amplifier is amplifying a signal for transmission), the system may be said to be in a transmit operational mode (or an "active operational mode"). A duration of time while the transceiver 110 has the IO terminals 120-123, 124-127 coupled through the transmitter lineup 140 during a transmit operational mode may be referred to as a transmit time interval. As used herein, the system 100 may be considered to be in an "active operational mode" during transmit time intervals.

Conversely, at other points in time, the processor circuit 101 may cause all of the switching elements 128, 129 simultaneously to complete a circuit between the processor-side and antenna-side IO terminals 120-123, 124-127 through the receiver lineup 144. When the system 100 is actively conveying RF signals through the receiver lineups 144 in this system configuration, the system may be said to be in a receive operational mode. A duration of time while the transceiver 110 has the IO terminals 120-123, 124-127 coupled through the receiver lineup 144 during a receive operational mode may be referred to as a receive time interval. In some instances, the system 100 may be in an idle mode during which the system is not conveying RF signals through either the transmitter lineups 140 or through the receiver lineups 144, but instead is idle or performing some other function (e.g., power up or diagnostic functions). As used herein, the system 100 may be considered to be in an "inactive operational mode" during receive time intervals and when the system 100 is in an idle mode. The term "inactive" is not meant to imply that the system 100 is not performing a function during an "inactive operational mode". Instead, the term is used just to differentiate times when the system 100 is actively transmitting RF signals (e.g., during transmit time intervals) from times when the system 100 is not actively transmitting RF signals.

Each receiver lineup 144 may include, for example, a low noise amplifier (LNA) 145 coupled to the input to the receiver lineup 144 (e.g., to the third terminal of switching element 129), an adjustable phase shifter 146 coupled to the output of the LNA 145, and a variable attenuator 147 coupled between the adjustable phase shifter 146 and the output of the receiver lineup 144 (e.g., the third terminal of switching element 128). During operation in the receive operational mode, switching elements 128, 129 are set to complete a circuit from an antenna-side IO terminal 124-127 through the receiver lineup 144 to a processor-side IO terminal 120-123. This enables an RF signal received over the air interface through an antenna element 104-107 to be amplified by the LNA 145, shifted in phase by the adjustable phase shifter 146, and attenuated by the variable attenuator 147 before being provided to a processor-side IO terminal 120-123. Coordinated control of the adjustable phase shifters 146 and the variable attenuators 147 in each of the transceivers 110 enables a receive beam that is propagated by the antenna elements 104-107 into the environment to be directed and "steered" in a particular direction by exploiting the principles of constructive and destructive signal interference.

Each transmitter lineup 140 may include, for example, a variable attenuator 142 coupled to the input to the transmitter lineup 140 (e.g., to the second terminal of switching element 128), an adjustable phase shifter 143 coupled to the variable attenuator 142, and a power amplifier module 150 coupled between the adjustable phase shifter 143 and the output of the transmitter lineup 140 (e.g., the second terminal of switching element 129). During operation in the transmit operational mode, switching elements 128, 129 are set to complete a circuit from an antenna-side IO terminal 124-127 through the transmitter lineup 140 to a processor-side IO terminal 120-123. This enables an RF signal received from the processor circuit 101 to be attenuated by the variable attenuator 142, shifted in phase by the adjustable phase shifter 143, and amplified by the power amplifier module 150 before being provided to an antenna-side IO terminal 124-127 (and ultimately to an antenna element 104-107 for radiation over the air interface). Again, coordinated control of the adjustable phase shifters 143 and the variable attenuators 142 in each of the transceivers 110 enables a transmit beam that is propagated by the antenna elements 104-107 into the environment to be directed and "steered" in a particular direction by exploiting the principles of constructive and destructive signal interference.

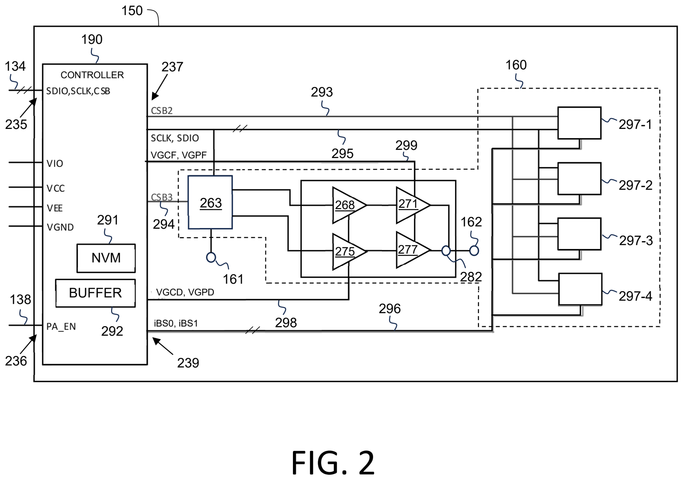

Referring to both FIGs 1 and 2, embodiments of the power amplifier module 150 (or more generically, an "electronic module") will now be described in more detail. First, it should be noted that the term "module," as used herein, refers to an electronic circuit that is housed on a module substrate (e.g., a printed circuit board or other substrate), and which electrically communicates with external devices (e.g., processor circuit 101, phase shifter 142, attenuator 143, antennas 104-107, and so on) through a plurality of module terminals (not shown). In some embodiments, the module substrate may be surface mounted to a system substrate, and the module terminals may be electrically connected to corresponding terminals on the system substrate using solder or other conductive connections.

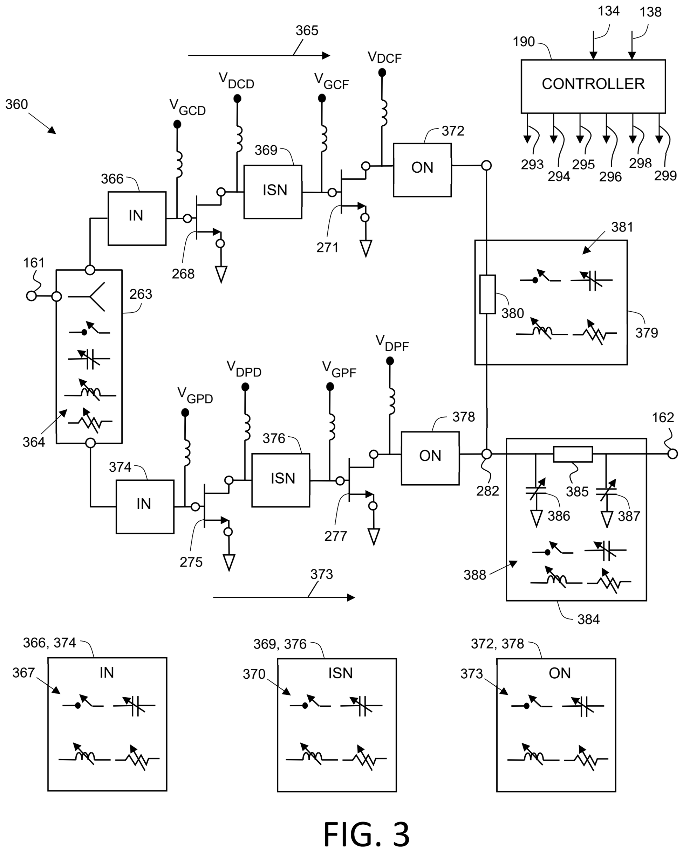

Power amplifier module 150 generally includes a power amplifier circuit 160 (or more generally, and "electronic circuit"), which has an input terminal 161 and an output terminal 162 (e.g., two of the terminals of the power amplifier module 150). As will be described later in conjunction with FIG. 3, the power amplifier circuit 160 may include, for example, a Doherty power amplifier (e.g., amplifier 360, FIG. 2), according to one or more embodiments. However, the power amplifier circuit 160 alternatively may include any of a variety of other types of amplifier circuits, in other embodiments.

The input terminal 161 of the power amplifier circuit 160 is electrically coupled (e.g., through phase shifter 142, attenuator 143, and switching element 128) to a processor-side IO (e.g., one of IOs 120-123), which in turn is electrically coupled to the signal IO of the processor circuit 101 through a transmission line (e.g., one of transmission lines 130), as described above. The output terminal 162 is electrically coupled (e.g., through switching element 129) to an antenna-side IO (e.g., one of IOs 124-127), which in turn is electrically coupled to an antenna element (e.g., one of antenna elements 103-107), as described above.

While in a transmit operational mode (e.g., during a transmit time interval), the power amplifier circuit 160 is configured to receive an input RF signal through the input terminal 161, to amplify the input RF signal to generate an amplified RF signal, and to convey the amplified RF signal to the output terminal 162 for transmission by an antenna element 104-107 over the air interface.

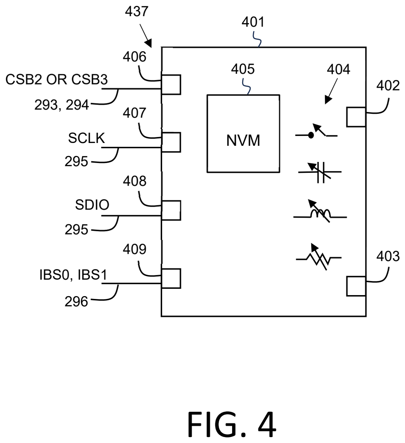

In addition, the power amplifier module 150 includes one or more reconfigurable devices (e.g., devices 263, 297-1, 297-2, 297-3, 297-4). As used herein, a "reconfigurable device" is an electronic device that includes, at least, a communications interface through which device configuration information may be received, and a reconfigurable electronic component. For example, a reconfigurable electronic component within a reconfigurable device may include a dynamic signal splitter, a tuner, a variable passive component (e.g., a variable capacitor, a variable inductor, a variable resistor), a switch, or another type of electronic component that may be controlled into any of a plurality of states, or may be controlled to have any of a plurality of component values (e.g., capacitance values, inductance values, resistance values, and so on). As will be discussed more later in conjunction with FIG. 4, a reconfigurable device also may include one or more data storage structures (e.g., NVM 405, FIG. 4), which are configured to store component state information (e.g., a portion of state table 700, FIG. 7). Additionally, a reconfigurable device may include a chip select input and a communications interface (e.g., a serial communications interface and IO lines), which enable configuration information to be communicated to the reconfigurable device.

In addition, the power amplifier module 150 includes a module controller circuit 190. The module controller circuit 190 includes an external control signal interface 235, which is electrically coupled through a communications bus 134 (e.g., a serial communications bus) to a corresponding control signal interface 132 of the processor circuit 101. According to one or more embodiments, the external control signal interface of the module controller circuit 190 is configured to be connected to a serial communications bus (i.e., communication bus 134 is a serial communications bus). As will be described in more detail below, module controller circuit 190 may receive various types of control information from the processor circuit 101 over the communications bus 134, including control information that enables the module controller circuit 190 to configure and reconfigure the various reconfigurable devices within the power amplifier circuit 160.

For example, according to various embodiments, the external control signal interface may be a SPI (Serial Peripheral Interface), I2C (Inter-Integrated Circuit), I3C (Improved Inter-Integrated Circuit), or other type of serial communications interface. As such, the external control signal interface may include, at least, one or more terminals for sending or receiving serial data (SDIO), and a terminal for conveying clock information (e.g., serial clock signal SCLK). More specifically, for example, when the external control signal interface is a SPI, the external control signal interface may include three terminals that may be coupled to a 3-wire communication bus 134 in order to support a half-duplex serial communications protocol, or alternatively the external control interface may include four terminals that may be coupled to a 4-wire communication bus 134 in order to support a full-duplex serial communications protocol. The four terminals may include, for example, a first terminal for receiving a serial clock signal (SCLK), a second terminal for receiving input data (SDIO 1), a third terminal for conveying output data (SDIO 2), and a fourth terminal coupled to a chip select line (CSB). Conversely, when the external control signal is an I2C or I3C serial communications interface, the external control signal interface may include at least two terminals that may be coupled to a 2-wire communication bus 134 in order to support a half-duplex serial communications protocol. The two terminals may include, for example, a first terminal for receiving a serial clock signal (SCLK), and a second terminal for receiving input data (in a receive mode) or for conveying output data (in a transmit mode) (SDIO).

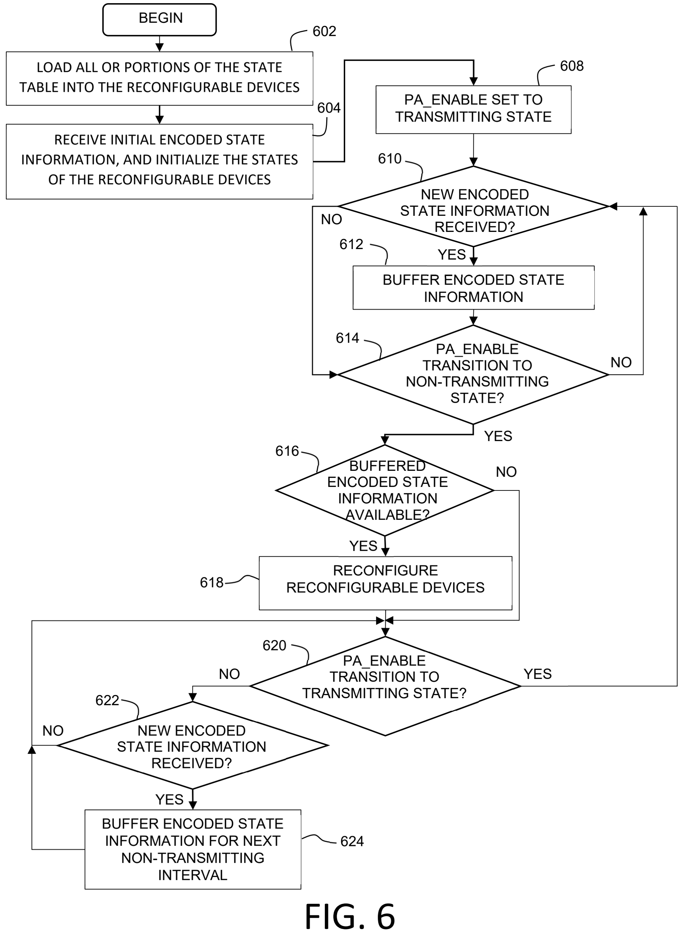

According to one or more embodiments, the module controller circuit 190 also includes one or more data storage structures, such as a non-volatile memory (NVM) 291 ("controller circuit data storage structure") and a buffer 292 (e.g., including one or more volatile data registers). Various data may be stored in the NVM 291 and the buffer 292 to facilitate the functions performed by the module controller circuit 190. For example, according to some embodiments, and as will be described in more detail later in conjunction with FIG. 6, the data stored in NVM 291 may include a portion of a state table (e.g., a portion of state table 700, FIG. 7), which includes device state information for all of the reconfigurable devices within the module 150. According to one or more embodiments, during a device initialization phase of operation (e.g., block 602, FIG. 6), the module controller circuit 190 may convey, to each of the reconfigurable devices, the device state information within the stored state table that is pertinent to each reconfigurable device. As will also be described in detail later in conjunction with FIG. 6, the buffer 292 may be utilized to store encoded state information received from the processor circuit 101 over the communications bus 134. The encoded state information that is stored within the buffer 292 at any given time identifies a particular system or module state from a plurality of possible states. According to one or more embodiments, the encoded state information (or other values derived from the encoded state information) may be conveyed to the reconfigurable devices within the module 150, and knowledge of the encoded state information enables the reconfigurable devices to determine which of a plurality of states the devices should configure themselves into.

According to one or more embodiments, the module controller circuit 190 also includes one or more additional IOs 236, which are coupled to one or more additional IO lines 138 between the module controller circuit 190 and the processor circuit 101. For example, the additional IOs 236 may include an enable signal input (or more specifically, a power amplifier enable signal input, PA_EN). The enable signal input is configured to receive a real-time control signal from the processor circuit 101, which indicates whether the system is in a transmit operational mode (also referred to herein as an active operational mode) or is in a non-transmit operational mode (e.g., a receive mode or idle mode, also referred to herein as an inactive operational mode). For example, when a signal received by the enable signal input over IO line 138 is high (e.g., has a high logic level), this may indicate that the system is in a transmit operational mode, and when the signal is low (e.g., has a low logic level), this may indicate that the system is in a non-transmit operational mode, or vice versa. As will be explained in more detail in conjunction with FIG. 6, the module controller circuit 190 is configured to initiate device reconfiguration operations when the signal received by the enable signal input indicates that the system has transitioned into a non-transmit operational mode (e.g., the system has transitioned from an active operational mode to an inactive operational mode).

According to one or more embodiments, the module controller circuit 190 also may include one or more voltage reference input terminals. For example, although not numbered in FIG. 2, module controller circuit 190 is shown to include three voltage input terminals, VIO, VCC, and VEE, which as explained below, are configured to receive DC voltage signals that may be converted by the module controller circuit 190 into bias voltages for the power amplifier circuit 160. In addition, module controller circuit 190 is shown to include a ground reference voltage terminal, VGND, which may be electrically coupled to a system ground reference node in order to provide ground connections to circuitry within the module controller circuit 190.

According to one or more embodiments, the module controller circuit 190 also includes an internal control signal interface 237, which is electrically coupled through a communications bus 295 (e.g., a serial communications bus) to corresponding control signal interfaces (e.g., terminals 407, 408, FIG. 4) of one or more reconfigurable devices (e.g., devices 263, 297-1, 297-2, 297-3, 297-4). As will be described in more detail below, module controller circuit 190 may convey at least a first part of the encoded state information to the reconfigurable devices over the communications bus 295, including encoded state information that enables the reconfigurable devices to configure and reconfigure themselves. For example, according to various embodiments, the internal control signal interface may be a SPI, I2C, I3C, or other type of serial communications interface. As such, the internal control signal interface may include, at least, one or more terminals for sending or receiving serial data (SDIO), and a terminal for conveying clock information (e.g., SCLK).

In addition, the internal control signal interface 237 may include a third terminal coupled to a first internal chip select line 293 (CSB2), and a fourth terminal coupled to a second internal chip select line 294 (CSB3). According to one or more embodiments, the third terminal and first internal chip select line 293 are coupled to chip select terminals (e.g., terminal 406, FIG. 4) of first reconfigurable devices (e.g., devices 297-1, 297-2, 297-3, 297-4), and the fourth terminal and second internal chip select line 294 are coupled to chip select terminal(s) (e.g., terminal 406, FIG. 4) of one or more second reconfigurable devices (e.g., device 263). When received, a chip select signal causes a reconfigurable device to prepare itself to receive data (e.g., configuration information) through the device's control signal interface.

Additionally, the module controller circuit 190 also may include one or more additional IOs 239 that are coupled to the one or more first reconfigurable devices (e.g., devices 297-1, 297-2, 297-3, 297-4) through one or more transmission lines 296. As will be described in more detail below, according to one or more embodiments, module controller circuit 190 may convey at least a second part of the encoded state information to the reconfigurable devices over the transmission lines 296, including additional encoded state information that enables the reconfigurable devices to configure and reconfigure themselves. Collectively, the communications bus 295 and the transmission lines 296 may be referred to as an internal control signal interface.

As mentioned above, according to one or more embodiments, the power amplifier circuit 160 may include, for example, a Doherty power amplifier (e.g., amplifier 360, FIG. 2), although, the power amplifier circuit 160 alternatively may include any of a variety of other types of amplifier circuits, in other embodiments. The depiction of power amplifier circuit 160 in FIG. 2 is a somewhat abstract and incomplete depiction of a Doherty power amplifier, and a more complete illustration of a Doherty power amplifier 360 that may be used for the power amplifier circuit 160 is shown in FIG. 3.

Referring to both FIGs 2 and 3, amplifier 160, 360 includes an input terminal 161, an output terminal 162, a splitter circuit 263, a first (e.g., carrier) amplification path 365, a second (e.g., peaking) amplification path 373, a combining node 282, and an output impedance transformer 384. Briefly, the splitter circuit 263 divides an input RF signal supplied at the input terminal 161, and the divided signals are separately amplified along the carrier and peaking amplification paths 365, 373. The amplified signals are then combined in phase at the combining node 282. It is important that phase coherency between the carrier and peaking amplification paths 365, 373 is maintained across a frequency band of interest to ensure that the amplified carrier and peaking signals arrive in phase at the combining node 282, and thus to ensure proper Doherty amplifier operation.

The Doherty power amplifier 160, 360 may include one or more reconfigurable devices, which are indicated generally in FIG. 2 with devices 297-1, 297-2, 297-3, and 297-4. It should be understood that devices 297-1 through 297-4 correspond to generic representations of any of the reconfigurable devices described below in conjunction with FIG. 3, including any of devices 367, 370, 373, 381, 386, 387, and 388. Although four reconfigurable devices 297-1 through 297-4 are shown in FIG. 2, it should be understood that the amplifier 160, 360 may have more or fewer than four reconfigurable devices, in various embodiments. As will be explained in more detail in conjunction with FIGs 4, 6, and 7, each of the reconfigurable devices 297-1 through 297-4 (and devices 367, 370, 373, 381, 386, 387, and 388, FIG. 3) may be individually addressable through a chip select terminal (e.g., terminal 406, FIG. 4).

The splitter circuit 263 has a splitter input coupled to the input terminal 161, a first splitter output coupled to an input of the carrier amplification path 365, and a second splitter output coupled to an input of the peaking amplification path 373. The splitter circuit 263 may divide the power of the input RF signal equally or unequally between the carrier and peaking amplification paths 365, 373. Generally, when the amplifier 160, 360 is a symmetrical Doherty power amplifier with equally-sized carrier and peaking amplifiers, the splitter circuit 263 may divide the power of the input RF signal equally between the carrier and peaking amplification paths 365, 373 (i.e., there is a 1:1 power split ratio between the carrier and peaking amplification paths 365, 373). Conversely, when the amplifier 160, 360 is an asymmetrical Doherty power amplifier with unequally-sized carrier and peaking amplifiers, the splitter circuit 263 may divide the power of the input RF signal unequally between the carrier and peaking amplification paths 365, 373 (i.e., there is a 1:x power split ratio between the carrier and peaking amplification paths 365, 373, where x typically is greater than 1).

According to one or more embodiments, the splitter circuit 263 also may be configured to apply a phase delay (e.g., a delay of about 90 degrees) to the RF signal that is provided through the second splitter output to the peaking amplification path 373. This phase delay is applied to compensate for a phase delay applied to the RF signal carried along the carrier amplification path 365 by the below-described phase shift and impedance inversion circuit 379. In an alternate embodiment, the phase delay applied along the peaking amplification path 373 may be applied by a phase shift element (not shown) that is external to the splitter circuit 263.

Either way, there may be a desire to be able to adjust the power split ratio slightly during operation of the Doherty power amplifier 160, 360 to account for manufacturing variances and/or dynamic impedance variances in the amplifier. Accordingly, in one or more embodiments, the splitter circuit 263 may include a dynamic splitter circuit, which includes one or more reconfigurable electronic components (e.g., variable passive components and/or switches), which are generally indicated in FIG. 3 with reference number 364. As mentioned previously, the variable passive components may include variable capacitors, variable inductors, variable resistors, and/or other types of variable components. The dynamic splitter circuit 263 may have any of a variety of circuit configurations, and the reconfigurable electronic components 364 may be included in various locations in the circuit. Each reconfigurable electronic component 364 may be utilized as a series-connected component (e.g., a component that forms a portion of the signal transmission path between the splitter input and a splitter output), or as a shunt-connected component (e.g., a component with a first terminal coupled to the signal transmission path, and a second terminal coupled to a ground reference node). In the latter case, for example, a shunt-connected circuit may include an inductor-capacitor (LC) circuit with an inductor and a capacitor connected in series between the signal transmission path and a ground reference node, where either or both the inductor and/or the capacitor may be a reconfigurable electronic component.

The carrier amplification path 365 is coupled between the first splitter output and the combining node 282. According to an embodiment, the carrier amplification path 365 includes an input network (IN) 366, a driver-stage amplifier transistor 268, an interstage network (ISN) 369, a final-stage amplifier transistor 271, an output network (ON) 372, and a phase shift and impedance inversion circuit 379 arranged in series as shown in FIG. 3.

The input network 366 may include, for example, an input impedance matching network and other circuitry, such as a harmonic termination circuit (e.g., an LC circuit coupled between the input to amplifier 268 and a ground reference node) and/or a baseband termination circuit. The impedance matching network of the input network 366 may have any of a variety of circuit configurations, including but not limited to T-matching networks, PI-matching networks, and/or other impedance matching topologies. In one or more embodiments, and as represented by the depiction of the input network 366 at the bottom left corner of FIG. 3, the input network 366 may include one or more reconfigurable electronic components (e.g., variable passive components and/or switches), which are generally indicated with reference number 367. Each reconfigurable electronic component 367 may be utilized as a series-connected component, or as a shunt-connected component, as described above. During operation of the Doherty power amplifier 160, 360, it may be desirable to reconfigure one or more of the reconfigurable electronic components 367 to adjust the performance of the amplifier.

The driver-stage amplifier transistor 268 may include a power transistor, for example, with an input terminal (e.g., a gate terminal) coupled to the input network 366, a first current-conducting terminal (e.g., a drain terminal) coupled to the interstage network 369, and a second current-conducting terminal (e.g., a source terminal) coupled to a ground reference node. The driver-stage amplifier transistor 268 is configured to apply a first level of gain to the RF signal being amplified along the carrier amplification path 365.

The interstage network 369 may include, for example, an interstage impedance matching network and other circuitry, such as one or more harmonic termination circuits (e.g., LC circuit(s) coupled between the output to amplifier 268 and/or the input to amplifier 271 and a ground reference node) and/or one or more baseband termination circuits. The impedance matching network of the interstage network 369 may have any of a variety of circuit configurations, including but not limited to T-matching networks, PI-matching networks, and/or other impedance matching topologies. In one or more embodiments, and as represented by the depiction of the interstage network 369 at the bottom center of FIG. 3, the interstage network 369 may include one or more reconfigurable electronic components (e.g., variable passive components and/or switches), which are generally indicated with reference number 370. Each reconfigurable electronic component 370 may be utilized as a series-connected component, or as a shunt-connected component, as described above. During operation of the Doherty power amplifier 160, 360, it may be desirable to reconfigure one or more of the reconfigurable electronic components 370 to adjust the performance of the amplifier.

The final-stage amplifier transistor 271 may include a power transistor, for example, with an input terminal (e.g., a gate terminal) coupled to the interstage network 369, a first current-conducting terminal (e.g., a drain terminal) coupled to the output network 372, and a second current-conducting terminal (e.g., a source terminal) coupled to a ground reference node. The final-stage amplifier transistor 271 is configured to apply an additional level of gain to the RF signal being amplified along the carrier amplification path 365.

The output network 372 may include, for example, an output impedance matching network and other circuitry, such as one or more harmonic termination circuits (e.g., LC circuit(s) coupled between the output to amplifier 271 and a ground reference node) and/or one or more baseband termination circuits. The impedance matching network of the output network 372 may have any of a variety of circuit configurations, including but not limited to T-matching networks, PI-matching networks, and/or other impedance matching topologies. In one or more embodiments, and as represented by the depiction of the output network 372 at the bottom right corner of FIG. 3, the output network 372 may include one or more reconfigurable electronic components (e.g., variable passive components and/or switches), which are generally indicated with reference number 373. Each reconfigurable electronic component 373 may be utilized as a series-connected component, or as a shunt-connected component, as described above. During operation of the Doherty power amplifier 160, 360, it may be desirable to reconfigure one or more of the reconfigurable electronic components 373 to adjust the performance of the amplifier.

The phase shift and impedance inversion circuit 379 is coupled between the output network 372 and the combining node 282. Circuit 379 is configured to impart a phase delay to the RF signal carried along the carrier amplification path 365 (e.g., a phase delay in a range of about 70 degrees to about 90 degrees), and also to apply an impedance inversion. Circuit 379 may include, for example, a transmission line 380 and one or more reconfigurable electronic components (e.g., variable passive components and/or switches), which are generally indicated with reference number 381. Each reconfigurable electronic component 381 may be utilized as a series-connected component, or as a shunt-connected component, as described above. During operation of the Doherty power amplifier 160, 360, it may be desirable to reconfigure one or more of the reconfigurable electronic components 381 to adjust the performance of the amplifier.

The peaking amplification path 373 is coupled between the second splitter output and the combining node 282. According to an embodiment, the peaking amplification path 373 includes an input network (IN) 374, a driver-stage amplifier transistor 275, an interstage network (ISN) 376, a final-stage amplifier transistor 277, and an output network (ON) 378 arranged in series as shown in FIG. 3.

The input network 374 may include, for example, an input impedance matching network and other circuitry, such as a harmonic termination circuit (e.g., an LC circuit coupled between the input to amplifier 275 and a ground reference node) and/or a baseband termination circuit. The impedance matching network of the input network 374 may have any of a variety of circuit configurations, including but not limited to T-matching networks, PI-matching networks, and/or other impedance matching topologies. In one or more embodiments, and as represented by the depiction of the input network 374 at the bottom left corner of FIG. 3, the input network 374 may include one or more reconfigurable electronic components (e.g., variable passive components and/or switches), which are generally indicated with reference number 367. Each reconfigurable electronic component 367 may be utilized as a series-connected component, or as a shunt-connected component, as described above. During operation of the Doherty power amplifier 160, 360, it may be desirable to reconfigure one or more of the reconfigurable electronic components 367 to adjust the performance of the amplifier.

The driver-stage amplifier transistor 275 may include a power transistor, for example, with an input terminal (e.g., a gate terminal) coupled to the input network 374, a first current-conducting terminal (e.g., a drain terminal) coupled to the interstage network 376, and a second current-conducting terminal (e.g., a source terminal) coupled to a ground reference node. The driver-stage amplifier transistor 275 is configured to apply a first level of gain to the RF signal being amplified along the peaking amplification path 373.

The interstage network 376 may include, for example, an interstage impedance matching network and other circuitry, such as one or more harmonic termination circuits (e.g., LC circuit(s) coupled between the output to amplifier 275 and/or the input to amplifier 277 and a ground reference node) and/or one or more baseband termination circuits. The impedance matching network of the interstage network 376 may have any of a variety of circuit configurations, including but not limited to T-matching networks, PI-matching networks, and/or other impedance matching topologies. In one or more embodiments, and as represented by the depiction of the interstage network 376 at the bottom center of FIG. 3, the interstage network 376 may include one or more reconfigurable electronic components (e.g., variable passive components and/or switches), which are generally indicated with reference number 370. Each reconfigurable electronic component 370 may be utilized as a series-connected component, or as a shunt-connected component, as described above. During operation of the Doherty power amplifier 160, 360, it may be desirable to reconfigure one or more of the reconfigurable electronic components 370 to adjust the performance of the amplifier.

The final-stage amplifier transistor 277 may include a power transistor, for example, with an input terminal (e.g., a gate terminal) coupled to the interstage network 376, a first current-conducting terminal (e.g., a drain terminal) coupled to the output network 378, and a second current-conducting terminal (e.g., a source terminal) coupled to a ground reference node. The final-stage amplifier transistor 277 is configured to apply an additional level of gain to the RF signal being amplified along the peaking amplification path 373.

The output network 378 may include, for example, an output impedance matching network and other circuitry, such as one or more harmonic termination circuits (e.g., LC circuit(s) coupled between the output to amplifier 277 and a ground reference node) and/or one or more baseband termination circuits. The impedance matching network of the output network 378 may have any of a variety of circuit configurations, including but not limited to T-matching networks, PI-matching networks, and/or other impedance matching topologies. In one or more embodiments, and as represented by the depiction of the output network 378 at the bottom right corner of FIG. 3, the output network 378 may include one or more reconfigurable electronic components (e.g., variable passive components and/or switches), which are generally indicated with reference number 373. Each reconfigurable electronic component 373 may be utilized as a series-connected component, or as a shunt-connected component, as described above. During operation of the Doherty power amplifier 160, 360, it may be desirable to reconfigure one or more of the reconfigurable electronic components 373 to adjust the performance of the amplifier.

During operation of Doherty power amplifier 160, 360, the carrier amplifier transistors 268, 271 receive gate bias voltages V_{GCD}, V_{GCF} and drain bias voltages V_{DCD}, V_{DCF}, and the peaking amplifier transistors 275, 277 receive gate bias voltages V_{GPD}, V_{GPF} and drain bias voltages V_{DPD}, V_{DPF}. According to one or more embodiments, and as shown in FIG. 2, the gate bias voltages V_{GCD}, V_{GCF} , V_{GPD}, V_{GPF} may be provided by the module controller circuit 190 through bias lines 298, 299. The drain bias voltages V_{DCD}, V_{DCF}, V_{DPD}, V_{DPF} may be provided through additional terminals (not illustrated). To ensure proper Doherty amplifier operation, the carrier amplifier transistor 271 is biased to operate in class AB mode, and the peaking amplifier transistor 277 is biased to operate in class C mode.

The output impedance transformer 384, which is configured to impart an output impedance transformation, is coupled between the combining node 282 and the output terminal 162. In one or more embodiments, the output impedance transformer 384 includes one or more reconfigurable electronic components (e.g., variable passive components and/or switches), including variable shunt capacitors 386, 387 and/or one or more other reconfigurable electronic components, which are generally indicated in FIG. 3 with reference number 388. As mentioned previously, the variable passive components may include variable capacitors, variable inductors, variable resistors, and/or other types of variable components. In the embodiment illustrated in FIG. 3, the output impedance transformer 384 includes a transmission line 395 coupled between the combining node 282 and the output terminal 162, variable shunt capacitor 386 coupled to a first end of the transmission line 395, and variable shunt capacitor 387 coupled to a second end of the transmission line 395. It should be understood that the output impedance transformer 384 may have a different circuit configuration, in other embodiments. Either way, during operation of the Doherty power amplifier 160, 360, it may be desirable to reconfigure one or more of the variable shunt capacitors 396, 397 or the other reconfigurable electronic components 388 to adjust the performance of the amplifier.

As discussed above, the module controller circuit 190 configures and reconfigures the various reconfigurable devices (e.g., devices 297-1 through 297-4, and 367, 370, 373, 381, 386, 387, and 388) within the power amplifier circuit 160, 360 through signals provided over chip select lines 293, 294, communications bus 295, and transmission lines 296. To facilitate a discussion of a method for the module controller circuit 190 to perform these actions in conjunction with FIGs 5-10, a depiction of a "generic" reconfigurable device 401 is shown in FIG. 4.

According to one or more embodiments, each reconfigurable device 401 includes a reconfigurable electronic component (indicated generally with reference number 404). The reconfigurable component includes input and output terminals coupled to device input terminal 402 and device output terminal 403, respectively. When incorporated into an electronic circuit (e.g., circuit 160 and/or amplifier 360), the device input and output terminals 402, 403 are connected to appropriate nodes within the circuit to electrically connect the reconfigurable electronic component 404 within the circuit.

As discussed previously, the reconfigurable components 404 may include, for example, a switch, a variable capacitor, a variable inductor, a variable resistor, or another type of variable component. When the reconfigurable electronic component is a switch, for example, the component may be configured (or reconfigured) to adjust the state of the switch (e.g., to open or close the switch, or to couple a common terminal to one or another output terminals). When the reconfigurable electronic component is a variable capacitor, for example, the component may include a variable capacitor or a switched capacitor network, which may be configured (or reconfigured) to adjust a capacitance value between the input and output terminals of the variable capacitor. When the reconfigurable electronic component is a variable inductor, for example, the component may include a mechanically-variable inductor or a switched inductor network, which may be configured (or reconfigured) to adjust an inductance value between the input and output terminals of the variable inductor. When the reconfigurable electronic component is a variable resistor, for example, the component may include a potentiometer, a variable resistor, or a switched resistor network, which may be configured (or reconfigured) to adjust a resistance value between the input and output terminals of the variable resistor. Although certain types of reconfigurable components are discussed herein, a reconfigurable device 401 may include other types of reconfigurable components, as well, including reconfigurable components that have more than two terminals.

As indicated above, some types of reconfigurable electronic components may be capable of being configured, at any given time, into one of two states (e.g., a switch may be configured into an open state or into a closed state). Other types of reconfigurable electronic components may be capable of being configured, at any given time, into one of many states. For example, when the reconfigurable electronic component is a variable capacitor, a variable inductor, or a variable resistor, the electronic component may be configured to have any of a plurality of capacitance values, inductance values, or resistance values, respectively. For example, a variable capacitor, a variable inductor, or a variable resistor may be configured into any of *M* discrete states (e.g., where *M* is between 2 and 32 (inclusive) states), with each state corresponding to a different capacitance value, inductance value, or resistance value.

According to one or more embodiments, to facilitate configuring or reconfiguring the reconfigurable electronic component within device 401, each reconfigurable device 401 also may include a control signal interface 437, through which the module controller circuit 190 may convey state information to the reconfigurable device 401 over communications bus 295. For example, the control signal interface 437 may have a first terminal 407 configured to be coupled to a clock line of the communications bus 295 in order to receive a serial clock signal, SCLK. Additionally, the control signal interface 437 may have a second terminal 408 configured to be coupled to a serial data line of the communications bus 295 in order to receive serial data, SDIO. For example, according to various embodiments, the control signal interface 437 may be a SPI, I2C, 13C, or other type of serial communications interface.

Additionally, each reconfigurable device 401 also may include one or more additional IO terminals 409, through which the module controller circuit 190 may convey additional state information to the reconfigurable device 401 over the transmission line(s) 296. As mentioned previously, the module controller circuit 190 may convey state information to the reconfigurable device 401 over the communications bus 295 and/or the transmission line(s) 296, including state information that enables the reconfigurable device 401 to configure and reconfigure itself.

Further still, each reconfigurable device 401 also may include a chip select input 406, which may be coupled to a chip select line (e.g., either of lines 293 or 294, FIG. 2), and through which the device 401 may receive a chip select signal (e.g., CSB2 or CSB3). When received, a chip select signal causes the reconfigurable device 401 to prepare itself to receive data (e.g., configuration information) through the device's control signal interface 437 and additional IO terminals 409.

According to one or more embodiments, a reconfigurable device 401 also may include one or more data storage structures (e.g., NVM 405), which is configured to store component state information (e.g., a portion of state table 700, FIG. 7). As will be described in more detail below, upon receiving a chip select signal (through terminal 406) and a device control signal (through terminals 407-409), the reconfigurable device 401 may access the component state information stored within the NVM 405 to determine which state the reconfigurable electronic component 404 should assume.

Operation of the communications system 100 will now be described in conjunction with FIGs 5-10. FIG. 5 is a flowchart of a method for a front end processor circuit (e.g., circuit 101, FIG. 1) to initiate configuration changes to a power amplifier module (e.g., to module 150, FIGs 1, 2), according to one or more embodiments. The method may begin, in block 502, when the processor circuit 101 distributes state information associated with configuring and reconfiguring the reconfigurable devices within the system to the controller circuits 190 of each of the power amplifier modules 150. This is done by loading state information into the controller circuits 190, as will be described below.

According to one or more embodiments, the state information for the reconfigurable devices may be encoded within a look up table, referred to herein as a "state table." Essentially, the state table identifies unique combinations of states for the reconfigurable devices based on current (or imminent) operating conditions of the system 100. In the state table, each unique combination of states (referred to as a "bank of states") corresponds to a particular circuit state, and the unique combination of states is associated with unique encoded state information. The encoded state information may include one or more relatively short value(s), and the front end processor circuit 101 may send the encoded state information to the power amplifier modules 150 to identify a particular unique combination of states for the reconfigurable devices within the power amplifier modules 150. According to an embodiment, the state table is stored in the NVM 102 of the processor circuit 101.

Referring briefly to FIG. 7, an example state table 700 is shown, which includes a plurality of rows (e.g., including rows 701-704) of configuration-related data, where each row includes a unique bank of states for the reconfigurable devices within a power amplifier module (e.g., module 150). Each bank of states is uniquely identified by a state index in column 710. Again, as used herein, the term "bank of states" refers to a unique combination of states (or configurations) for the reconfigurable devices within the power amplifier modules 150, and each bank of states corresponds to a particular circuit state of a plurality of possible circuit states for a power amplifier module 150.

As mentioned previously, some reconfigurable devices may be configured into only two states (e.g., a switch may have an open state and a closed state), whereas other devices may have multiple states. For the purposes of example only, the example values reflected in state table 700 assumes that any reconfigurable capacitors, inductors, and resistors may be configured, at any given time, into any of 16 unique states (with state values ranging from 0 to 15), where each state corresponds to a different capacitance, inductance, or resistance value, respectively. It should be understood that reconfigurable devices alternatively may be configured into fewer or more unique states, as well. As used herein, the values in columns 713-716 correspond to component settings or states of the reconfigurable electronic components within the reconfigurable devices.

The example state table 700 of FIG. 7 includes sixteen banks of states (16 rows), and each bank of states includes a unique combination of state data for the reconfigurable devices within the power amplifier modules 150. The example table 700 contemplates that each power amplifier module 150 includes four reconfigurable devices (e.g., devices 297-1 through 297-4, FIG. 2), although each power amplifier module 150 may include fewer or more reconfigurable devices (e.g., power amplifier module 150, FIG. 2, is shown it include five reconfigurable devices 263, and 297-1 through 297-4, and Doherty power amplifier 360 is shown to include many reconfigurable devices 364, 367, 370, 373, 381, 386, 387, 388).

In some embodiments, the state table 700 is pre-populated, and the component settings within each bank may be selected to optimize amplifier performance at a particular fundamental frequency of operation and at a particular load state. According to one or more embodiments, the table 700 includes sixteen combinations of four operational frequencies (column 717) and four load states (column 718). For example, bank 1 (row 701) includes device state data (component settings in columns 713-716) for four reconfigurable devices that correspond to system operation at a fundamental frequency of 3400 megahertz (MHz) and a nominal (NOM) load state. Bank 6 (row 702) includes device state data (component settings in columns 713-716) for four reconfigurable devices that correspond to system operation at a fundamental frequency of 3500 MHz and a load state that is 3 decibels (dB) below nominal. Bank 11 (row 703) includes device state data (component settings in columns 713-716) for four reconfigurable devices that correspond to system operation at a fundamental frequency of 3700 MHz and a load state that is 6 dB below nominal. Bank 16 (row 704) includes device state data (component settings in columns 713-716) for four reconfigurable devices that correspond to system operation at a fundamental frequency of 3800 MHz and a load state that is 12 dB below nominal.

The state table 700 also includes unique encoded state information for each bank of states. According to one or more embodiments, the encoded state information includes two parts: a first encoded value stored in column 711, and a second encoded value stored in column 712. The first encoded value may correspond to a relatively slowly changing operational condition, and all banks of states (rows) that correspond to that slowly changing operational condition may have the same first encoded value. For example, the relatively slowly changing operational condition may be the operational frequency (column 717), and all banks of states with the same operational frequency may have the same first encoded value in row 711. For example, with reference to column 717, the first four banks of states in the state table 700 each correspond to an operational frequency of 3400 MHz, and thus each of the first four banks of states has the same first encoded value of "1" (referred to as a "page" value) in row 711. As will be described in more detail below, to initiate reconfiguration of the reconfigurable devices within the power amplifier modules 150, the processor circuit 101 may send the first encoded value for a selected bank of states to the controller circuits 150 over communication bus 134, and each module controller circuit 190 may send the first encoded value to the reconfigurable devices within the power amplifier module 150 over communication bus 295, according to one or more embodiments.

The second encoded value may correspond to a relatively quickly changing operational condition, and all banks of states (rows) that correspond to that quickly changing operational condition may have the same second encoded value. For example, the relatively quickly changing operational condition may be the load condition (column 718), and all banks of states with the same load condition may have the same second encoded value in row 712. For example, the first, fifth, ninth, and thirteenth banks of states in the state table 700 each correspond to a nominal load condition (NOM), and thus each of these banks of states has the same second encoded value of "00b" (referred to as an "iBSsl, iBS0" value) in row 712. As will be described in more detail below, to initiate reconfiguration of the reconfigurable devices within the power amplifier modules 150, simultaneously with sending the first encoded value, the processor circuit 101 may send the second encoded value for a selected bank of states to the controller circuits 150 over communication bus 134, and each module controller circuit 190 may send the second encoded value to the reconfigurable devices within the power amplifier module 150 over transmission lines 296, according to one or more embodiments.

Referring again to block 502 of FIG. 5, the processor circuit 101 may distribute the state information (e.g., all or portions of table 700) to the controller circuits 190 of each of the power amplifier modules 150 during a startup or idle period (e.g., a period of time when the system 100 is not transmitting or receiving RF signals). Distributing the state information may include, for example, loading all or portions of the state table 700 into the NVM 291 (FIG. 2) of each module controller circuit 190 through the communications bus 134. More specifically, assuming that the processor circuit 101 and the module controller circuits 190 implement a serial communications protocol to communicate, the processor circuit 101 may utilize the communications bus 134 to clock data representing the state table 700 into the NVM 291 of each module controller circuit 190. Some of the information within the state table 700 (e.g., the information in columns 717 and 718) may not be relevant to the operations performed by the module controller circuits 190, and accordingly, the processor circuit 101 may distribute only part of the state table 700 to the module controller circuits 190 (e.g., the portion of state table 700 enclosed in dashed box 720).

In block 504, the processor circuit 101 may then determine a desired initial operational state based on user inputs and/or the current operational conditions of the system, and may select a bank of states from the state table 700 that corresponds to the initial operational state and current operational conditions. For example, in some embodiments, the processor circuit 101 may receive inputs from a user or other sources that enable the processor circuit to determine the operational frequency and the current load condition. Based on those inputs, the processor circuit 101 may identify the bank of states within table 700 that most closely corresponds to the operational conditions (operational frequency and load condition). For example, when the processor circuit 101 determines that the operational frequency is 3500 MHz and the load condition is 3 dB below nominal, the processor circuit 101 may select bank 6 (row 702) to use to initially configure the reconfigurable devices of the system.

In block 506, after selecting an initial bank of states, the processor circuit 101 identifies the encoded state information associated with that bank of states (e.g., the information in columns 711 and 712 of row 702 of table 700), and communicates the encoded state information to the controller circuits 190. As mentioned above, the encoded state information may include first and second encoded values (e.g., encoded values in columns 711 and 712), and the processor circuit 101 may send the first and second encoded values for a selected bank of states to the controller circuits 150 over communication bus 134, according to one or more embodiments. In alternate embodiments, the encoded state information may include a single value that the processor circuit 101 conveys to the controller circuits 150, and/or the processor circuit 101 may convey the encoded state information to the controller circuits 150 over a communication interface other than the communication bus 134. Utilization of the encoded state information by the controller circuits 150 will be discussed in detail later in conjunction with FIG. 6.

After sending the initial encoded state information to establish an initial circuit state, then in block 508, the processor circuit 101 waits for some trigger to occur that may warrant a reconfiguration operation. For example, the trigger may be the receipt of a new user input and/or a detection that the current operational conditions of the system have changed (e.g., the operational frequency and/or load condition has changed). When a determination is made that a reconfiguration operation should occur, then in block 510, the processor circuit 101 may determine a new operational state based on the user input or the altered operational conditions. Again, this may include the processor circuit 101 selecting a bank of states from the state table 700 that most closely corresponds to the new operational state and current operational conditions. For example, when the processor circuit 101 determines that the operational frequency has changed to 3700 MHz and the load condition is 6 dB below nominal, the processor circuit 101 may select bank 11 (row 703) to use to reconfigure the reconfigurable devices of the system.

In block 512, after selecting the new bank of states, the processor circuit 101 identifies the encoded state information associated with that bank of states (e.g., the information in columns 711 and 712 of row 703 of table 700), and communicates the encoded state information to the controller circuits 190, as described in conjunction with block 506. Once again, utilization of the encoded state information by the controller circuits 150 will be discussed in detail later in conjunction with FIG. 6. The processor circuit 101 then returns to waiting for some trigger to occur that may warrant another reconfiguration operation.

FIG. 6 is a flowchart of a method for a power amplifier module (e.g., each of power amplifier modules 150, FIGs 1, 2) to configure and reconfigure devices within each module 150, according to one or more embodiments. With reference also to FIGs 2 and 4, the method may begin, in block 602, when the module controller circuit 190 within each power amplifier module 150 distributes previously-loaded state information into each of the reconfigurable devices (e.g., devices 263, 297-1 through 297-4, 364, 367, 370, 373, 379, 386, 387, 388) within the power amplifier module 150. As discussed above in conjunction with step 502 of FIG. 5, the state information may have been previously loaded by the processor circuit 101 into the NVM 291 of each module controller circuit 190, and step 502 involves each module controller circuit 190 further distributing relevant state information to each of the reconfigurable devices within each module 150.

According to one or more embodiments, the controller circuits 190 of each of the power amplifier modules 150 may distribute the state information to the reconfigurable devices during a startup or idle period (e.g., a period of time when the system 100 is not transmitting or receiving RF signals). Distributing the state information may include, for example, loading all or portions of the previously-loaded state table 700 into the NVM 405 (FIG. 4) of each reconfigurable device through the communications bus 295. More specifically, assuming that the module controller circuits 190 and the reconfigurable devices implement a serial communications protocol to communicate, each module controller circuit 190 may utilize the communications bus 295 to clock data representing relevant portions of the state table 700 into the NVM 405 of each reconfigurable device. According to one or more embodiments, only information within the state table that is pertinent to a particular reconfigurable device is loaded into that reconfigurable device. This may include, for example, the information in columns 710-712, plus the information in only one of the columns 713-716 (e.g., whichever column corresponds to the particular reconfigurable device). For example, whereas a module controller circuit 190 may load state table information for a first device (e.g., state table information in column 713 for DEV 1) into that first device, the module controller circuit 190 may not load state table information for other devices (e.g., state table information in columns 714-716 for DEVs 2-4) into the first device. In other words, only a part of the state table 700 (e.g., the portion of state table 700 enclosed in dashed box 730) is loaded into the first device.

As discussed above in conjunction with block 506 of FIG. 5, each module controller circuit 190 may receive initial encoded state information from the processor circuit 101, which indicates a desired initial state for each module 150. In block 604, upon receiving the initial encoded state information, each module controller circuit 190 may initialize the states of each of the reconfigurable devices by conveying the initial encoded state information to the reconfigurable devices.

As discussed above, the encoded state information may include first and second encoded values (e.g., encoded values in columns 711 and 712 of table 700). According to one or more embodiments, the module controller circuit 190 conveys the first encoded value of the initial encoded state information to the reconfigurable devices by activating the appropriate chip select signal(s) (e.g., over chip select lines 293 and/or 294), and clocking the first encoded value into the reconfigurable devices over communication interface 295. According to one or more further embodiments, the module controller circuit 190 conveys the second encoded value of the initial encoded state information to the reconfigurable devices over the additional IO lines 296.

Dividing the encoded state information into first and second encoded values, and communicating those values over communication interface 295 and IO lines 296, respectively, provides a particular technical advantage. In particular, communicating the encoded state information in this manner strikes a balance between minimizing a number of IO lines 296 while ensuring that the system is responsive to more rapidly changing variables (e.g., load information). Specifically, configuration information that may change more rapidly (e.g., load information) may be conveyed quickly over the IO lines 296, while configuration information that may change more slowly (e.g., operational frequency) may be conveyed less frequently over the communications interface 295. It may be noted here that, in alternate embodiments, the encoded state information may include only a single value that may be communicated over only the communication interface 295 or over the IO lines 296.

Once the initial encoded state information has been conveyed to the reconfigurable devices, each device correlates the received initial encoded state information with the portion of the state table stored in NVM 405. In this manner, each reconfigurable device may determine into which state it should configure its reconfigurable electronic component. Each reconfigurable device thereafter configurates its reconfigurable electronic component into that state. When the reconfigurable electronic component includes a switch, for example, the reconfigurable device establishes a switch state that corresponds to the encoded state information. When the reconfigurable electronic component includes a variable capacitor, a variable inductor, or a variable resistor, for example, the reconfigurable device establishes a capacitance, inductance, or resistance value that corresponds to the encoded state information. At this point, the initial states of the reconfigurable devices (and the initial state of the modules 150) are established.

At some point, the system 100 will enter an operational phase in which the system begins communicating using a TDD communications protocol. Using TDD, the system transmits signals during transmit time intervals, and receives signals during receive time intervals. As mentioned previously, the system 100 may be considered to be in an "inactive operational mode" during receive time intervals (and when the system 100 is in an idle mode), and the system 100 may be considered to be in an "active operational mode" during transmit time intervals.

As reflected in the remainder of the flowchart, the various embodiments described herein enable changes to the configurations of reconfigurable devices within the power amplifier modules 150 only while the module is in an "inactive operational mode" (e.g., during a non-transmit time interval), thus avoiding the creation of errors or distortions in the RF signal that otherwise may have occurred if such reconfigurations were performed while the module is in an "active operational mode" (e.g., during a transmit time interval).

The state of the PA_ENABLE signal received by the controller circuit IO 236 over transmission line 138 indicates whether the system is in an active or inactive operational mode (e.g., whether a transmit time interval is occurring or not). According to one or more embodiments, the module controller 190 avoids reconfiguring the reconfigurable devices while the system is in an active operational mode (e.g., when a transmit time interval is occurring), and instead waits to reconfigure the reconfigurable devices while the system is in an inactive operational mode.

As indicated in FIG. 6 and block 608, the PA_ENABLE signal will have a value indicating that the system 100 is in an active operational mode at some point in time. Even during an active operational mode, the module controller circuit 190 may receive new encoded state information from the processor circuit 101, indicating that a reconfiguration should occur. As indicated in block 610, when the module controller circuit 190 receives new encoded state information from the processor circuit 101 during an active operational mode, the module controller circuit 190 stores the encoded state information in buffer 292 in block 612.

In block 614, the module controller circuit 190 monitors the PA_ENABLE signal to determine when the system 100 transitions from the active operational mode to an inactive operational mode (e.g., when the PA_ENABLE signal transitions from high to low). Until a transition from the active operational mode to an inactive operational mode occurs, the module controller circuit 190 continues to monitor the PA_ENABLE signal (in block 614) and buffer (in block 612) any new encoded state information that it may receive from the processor circuit 101. Detecting a transition of the PA_ENABLE signal from high to low in block 614 indicates that the system 100 has entered into a non-transmitting state, and it is safe to reconfigure the reconfigurable devices.

Upon such a transition, the module controller circuit 190 may determine if buffered encoded state information is available, in block 616. Buffered encoded state information may be available, for example, when the module controller circuit 190 has received and stored encoded state information during an active operational mode. When buffered encoded state information is available, then in block 618, the module controller circuit 190 may reconfigure the states of each of the reconfigurable devices by conveying the buffered encoded state information to the reconfigurable devices, as discussed in detail above in conjunction with the description of block 604.

In block 620, the module controller circuit 190 then monitors for another transition of the PA_ENABLE signal, indicating that the system 100 has once again entered into an active operational mode (e.g., a transmit operational mode). Before that transition occurs, as indicated in block 622, the module controller circuit 190 may receive new encoded state information from the processor circuit 101. In other words, the module controller circuit 190 may receive new encoded state information from the processor circuit 101 while the system 100 is in an inactive operational mode. It is desirable not to initiate a device reconfiguration process based on encoded state information received during an inactive operational mode (e.g., during a receive time interval), because the process may not have time to complete before the system 100 enters the next active operational period. Accordingly, when new encoded state information is received during an inactive operational mode (e.g., during a receive time interval), the module controller circuit 190 buffers the encoded state information, in block 624, by storing it in the NVM 291 of the module controller circuit 190. The module controller circuit 190 then returns to monitoring the PA_ENABLE signal, in block 620, until a transition to an active operational mode occurs. At that time, the process returns to block 610. Ultimately, once a PA_ENABLE transition is detected in block 614, any buffered encoded state information will be used to reconfigure the reconfigurable devices.

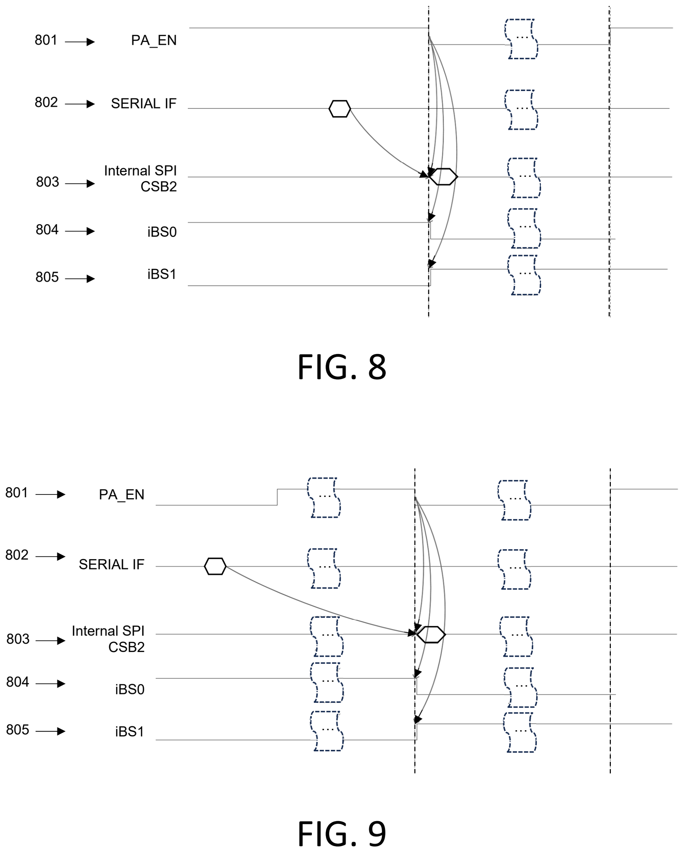

FIG. 8 is a first timing diagram that depicts timing for making synchronized configuration changes to reconfigurable devices, according to one or more embodiments. The timing diagram includes trace 801 that indicates the state of the PA_ENABLE signal, trace 802 that indicates whether or not data (e.g., encoded state information) from the processor circuit 101 is being received by the module controller circuit 190 over the external communications bus 134, trace 803 that indicates when data (e.g., the first encoded values of the encoded state information) is being communicated by the module controller circuit 190 to the reconfigurable devices over the internal communications bus 295, and traces 804 and 805 that indicate the states of signals on the IO lines 296 (e.g., indicating the second encoded values of the encoded state information).

Essentially, the first timing diagram conveys a scenario in which encoded state information (trace 802) is received when the system 100 is in an active operational mode during a transmit time interval (i.e., at a time when the PA_ENABLE signal trace 801 is high). Under this scenario, the module controller circuit 190 buffers the encoded state information. When the system 100 transitions to an inactive operational mode (e.g., when the PA_ENABLE signal trace 801 transitions to low), the module controller circuit 190 sends the first encoded value of the encoded state information to the reconfigurable devices over the internal communications bus 295, as indicated by trace 803. In addition, the module controller circuit 190 conveys the second encoded value of the encoded state information to the reconfigurable devices over IO lines 296.

FIG. 9 is a second timing diagram that depicts timing for making synchronized configuration changes to reconfigurable devices, according to one or more embodiments. Essentially, the second timing diagram conveys a scenario in which encoded state information (trace 802) is received when the system 100 is in an inactive operational mode (i.e., at a time when the PA_ENABLE signal trace 801 is low). Under this scenario, instead of initiating a device reconfiguration operation during while in the inactive operational mode, the module controller circuit 190 also buffers the encoded state information. Not until the system 100 transitions to the next inactive operational mode (e.g., after the PA_ENABLE signal trace 801 transitions to high, completes the transmit time interval, and again transitions to low), does the module controller circuit 190 send the first encoded value of the encoded state information to the reconfigurable devices over the internal communications bus 295, as indicated by trace 803. In addition, at that time, the module controller circuit 190 conveys the second encoded value of the encoded state information to the reconfigurable devices over IO lines 296. Delaying the reconfiguration operation until the next full inactive operational period ensures that the reconfiguration operation may complete during an inactive operational period.

An embodiment of an electronic module includes an electronic circuit and a controller circuit. The electronic circuit that includes a first reconfigurable device that includes a first electronic component that is capable of being configured into any one of a first plurality of component states at any given time, and a second reconfigurable device that includes a second electronic component that is capable of being configured into any one of a second plurality of component states at any given time. The controller circuit is coupled to the electronic circuit, and the controller circuit includes an external control signal interface configured to receive encoded state information that indicates that the electronic circuit is to be configured into a selected circuit state of multiple circuit states, an enable signal input configured to receive an enable signal that indicates whether the electronic circuit is in an active operational mode or in an inactive operational mode, and an internal control signal interface coupled to the first and second reconfigurable devices. After the controller circuit has received the encoded state information, and when the enable signal indicates that the electronic circuit has transitioned from the active operational mode into the inactive operational mode, the controller circuit is configured to send the encoded state information through the internal control signal interface to the first and second reconfigurable devices. The encoded state information causes the first reconfigurable device to configure the first electronic component into a first-component state that corresponds to the selected circuit state, and causes the second reconfigurable device to configure the second electronic component into a second-component state that corresponds to the selected circuit state.

An embodiment of an electronic system includes a processor circuit and multiple electronic modules. The processor circuit includes a plurality of electronic module interfaces, wherein each electronic module interface includes a signal input/output (IO), a control signal interface, and an enable signal output. Each electronic module of the multiple electronic modules includes a transmitter circuit coupled to the transmit signal output of one of the multiple electronic module interfaces of the processor circuit, and a controller circuit coupled to the transmitter circuit. The transmitter circuit includes a first reconfigurable device that includes a first electronic component that is capable of being configured into any one of a first plurality of component states at any given time, and a second reconfigurable device that includes a second electronic component that is capable of being configured into any one of a second plurality of component states at any given time. The controller circuit includes an external control signal interface coupled to the control signal interface of one of the multiple electronic module interfaces of the processor circuit, an enable signal input coupled to the enable signal output of one of the multiple electronic module interfaces of the processor circuit, and an internal control signal interface coupled to the first and second reconfigurable devices. The external control signal interface is configured to receive encoded state information from the processor circuit that indicates that the electronic circuit is to be configured into a selected circuit state of multiple circuit states. The enable signal input is configured to receive an enable signal from the processor circuit that indicates whether the electronic circuit is in an active operational mode or in an inactive operational mode. After the controller circuit has received the encoded state information, and when the enable signal indicates that the electronic circuit has transitioned from the active operational mode into the inactive operational mode, the controller circuit is configured to send the encoded state information through the internal control signal interface to the first and second reconfigurable devices, wherein the encoded state information causes the first reconfigurable device to configure the first electronic component into a first-component state that corresponds to the selected circuit state, and causes the second reconfigurable device to configure the second electronic component into a second-component state that corresponds to the selected circuit state.

An embodiment of a method of operating an electronic module includes receiving and processing a signal by an electronic circuit of the electronic module. The electronic circuit includes a first reconfigurable device that includes a first electronic component that is capable of being configured into any one of a first plurality of component states at any given time, and a second reconfigurable device that includes a second electronic component that is capable of being configured into any one of a second plurality of component states at any given time. The method further includes receiving, by a controller circuit of the electronic module over an external control signal interface, encoded state information that indicates that the electronic circuit is to be configured into a selected circuit state of multiple circuit states. The method further includes receiving, by the controller circuit over an enable signal input, an enable signal that indicates whether the electronic circuit is in an active operational mode or in an inactive operational mode. After the controller circuit has received the encoded state information, and when the enable signal indicates that the electronic circuit has transitioned from the active operational mode into the inactive operational mode, the method includes sending, by the controller circuit through an internal control signal interface, the encoded state information to the first and second reconfigurable devices. The method further includes configuring, by the first reconfigurable device in response to receiving the encoded state information, the first electronic component into a first-component state that corresponds to the selected circuit state, and configuring, by the second reconfigurable device in response to receiving the encoded state information, the second electronic component into a second-component state that corresponds to the selected circuit state.

In one or more embodiments, the method further comprises: storing, by the controller circuit in a controller circuit data storage structure, a first state table that includes first state data corresponding to a first circuit state of the multiple circuit states, and second state data corresponding to a second circuit state of the multiple circuit states, wherein

the first state data includes a first state index, a first-state component setting for the first electronic component, and a first-state component setting for the second electronic component, and the second state data includes a second state index, a second-state component setting for the first electronic component, and a second-state component setting for the second electronic component.

In one or more embodiments, the first reconfigurable device includes a first device data storage structure configured to store a second state table that includes at least a first portion of the first state data and at least a first portion of the second state data; and

the second reconfigurable device includes a second device data storage structure configured to store a third state table that includes at least a second portion of the first state data and at least a second portion of the second state data.

In one or more embodiments, during an initialization phase of operation, sending, by the controller circuit through the internal control signal interface, the second state table to the first reconfigurable device, and the third state table to the second reconfigurable device.

The preceding detailed description is merely illustrative in nature and is not intended to limit the embodiments of the subject matter or the application and uses of such embodiments. As used herein, the word "exemplary" means "serving as an example, instance, or illustration." Any implementation described herein as exemplary is not necessarily to be construed as preferred or advantageous over other implementations. Furthermore, there is no intention to be bound by any expressed or implied theory presented in the preceding technical field, background, or detailed description.

The connecting lines shown in the various figures contained herein are intended to represent exemplary functional relationships and/or physical couplings between the various elements. It should be noted that many alternative or additional functional relationships or physical connections may be present in an embodiment of the subject matter. In addition, certain terminology may also be used herein for the purpose of reference only, and thus are not intended to be limiting, and the terms "first", "second" and other such numerical terms referring to structures do not imply a sequence or order unless clearly indicated by the context.

As used herein, a "node" means any internal or external reference point, connection point, junction, signal line, conductive element, or the like, at which a given signal, logic level, voltage, data pattern, current, or quantity is present. Furthermore, two or more nodes may be realized by one physical element (and two or more signals can be multiplexed, modulated, or otherwise distinguished even though received or output at a common node).

The foregoing description refers to elements or nodes or features being "connected" or "coupled" together. As used herein, unless expressly stated otherwise, "connected" means that one element is directly joined to (or directly communicates with) another element, and not necessarily mechanically. Likewise, unless expressly stated otherwise, "coupled" means that one element is directly or indirectly joined to (or directly or indirectly communicates with, electrically or otherwise) another element, and not necessarily mechanically. Thus, although the schematic shown in the figures depict one exemplary arrangement of elements, additional intervening elements, devices, features, or components may be present in an embodiment of the depicted subject matter.

While at least one exemplary embodiment has been presented in the foregoing detailed description, it should be appreciated that a vast number of variations exist. It should also be appreciated that the exemplary embodiment or embodiments described herein are not intended to limit the scope, applicability, or configuration of the claimed subject matter in any way. Rather, the foregoing detailed description will provide those skilled in the art with a convenient road map for implementing the described embodiment or embodiments. It should be understood that various changes can be made in the function and arrangement of elements without departing from the scope defined by the claims, which includes known equivalents and foreseeable equivalents at the time of filing this patent application.

## Claims

1. An electronic module comprising:
an electronic circuit that includes a first reconfigurable device that includes a first electronic component that is capable of being configured into any one of a first plurality of component states; and
a controller circuit coupled to the electronic circuit, wherein the controller circuit includes
an external control signal interface configured to receive encoded state information that indicates that the electronic circuit is to be configured into a selected circuit state of multiple circuit states,
an enable signal input configured to receive an enable signal that indicates whether the electronic circuit is in an active operational mode or in an inactive operational mode, and
an internal control signal interface coupled to the first reconfigurable device, wherein, after the controller circuit has received the encoded state information, and when the enable signal indicates that the electronic circuit has transitioned from the active operational mode into the inactive operational mode, the controller circuit is configured to send the encoded state information through the internal control signal interface to the first reconfigurable device, wherein the encoded state information causes the first reconfigurable device to configure the first electronic component into a first component state that corresponds to the selected circuit state.

2. The electronic module of claim 1, wherein:
the electronic circuit further includes a second reconfigurable device that includes a second electronic component that is capable of being configured into any one of a second plurality of component states; and
the internal control signal interface also is coupled to the second reconfigurable device, wherein, after the controller circuit has received the encoded state information, and when the enable signal indicates that the electronic circuit has transitioned from the active operational mode into the inactive operational mode, the controller circuit is configured to send the encoded state information through the internal control signal interface to the second reconfigurable device, wherein the encoded state information causes the second reconfigurable device to configure the second electronic component into a second component state that corresponds to the selected circuit state.

3. The electronic module of claim 2, wherein the controller circuit further comprises:
a controller circuit data storage structure configured to store a first state table that includes first state data corresponding to a first circuit state of the multiple circuit states, and second state data corresponding to a second circuit state of the multiple circuit states, wherein
the first state data includes a first state index, a first component setting for the first electronic component, and a second component setting for the second electronic component, and
the second state data includes a second state index, a third component setting for the first electronic component, and a fourth component setting for the second electronic component.

4. The electronic module of claim 3, wherein:
the first reconfigurable device includes a first device data storage structure configured to store a second state table that includes at least a first portion of the first state data and at least a first portion of the second state data; and
the second reconfigurable device includes a second device data storage structure configured to store a third state table that includes at least a second portion of the first state data and at least a second portion of the second state data.

5. The electronic module of claim 4, wherein:
during a device initialization phase of operation, the controller circuit is further configured to send, through the internal control signal interface, the second state table to the first reconfigurable device, and the third state table to the second reconfigurable device.

6. The electronic module of any preceding claim, wherein the first electronic component includes a component selected from a dynamic signal splitter, a tuner, a switch, a variable capacitor, a variable inductor, and a variable resistor.

7. The electronic module of any preceding claim, wherein the electronic circuit is a power amplifier circuit, and the active operational mode corresponds to a first time interval during which the power amplifier circuit is amplifying a signal to be transmitted.

8. The electronic module of claim 7, wherein the electronic module forms a portion of a transceiver that includes a receiver circuit, the transceiver operates using time division duplexing, and the inactive operational mode corresponds to a second time interval during which the receiver circuit is receiving signals from an antenna.

9. The electronic module of claim 7, wherein the controller circuit is further configured to provide one or more bias voltages to the power amplifier circuit through one or more bias lines.

10. The electronic module of any preceding claim, wherein the electronic circuit is a Doherty power amplifier that includes a carrier amplification path and a peaking amplification path, and wherein the first reconfigurable device is included in a signal splitter, the carrier amplification path, the peaking amplification path, or an output impedance transformer.

11. An electronic system comprising:
a processor circuit that includes a plurality of electronic module interfaces, wherein each electronic module interface includes a signal output terminal, a control signal interface, and an enable signal output; and
multiple electronic modules, wherein each electronic module of the multiple electronic modules includes
a transmitter circuit coupled to the signal output terminal of one of the multiple electronic module interfaces of the processor circuit, wherein the transmitter circuit includes
a first reconfigurable device that includes a first electronic component that is capable of being configured into any one of a first plurality of component states at any given time, and
a second reconfigurable device that includes a second electronic component that is capable of being configured into any one of a second plurality of component states at any given time; and
a controller circuit coupled to the transmitter circuit, wherein the controller circuit includes
an external control signal interface coupled to the control signal interface of one of the multiple electronic module interfaces of the processor circuit, wherein the external control signal interface is configured to receive encoded state information from the processor circuit that indicates that the electronic circuit is to be configured into a selected circuit state of multiple circuit states,
an enable signal input coupled to the enable signal output of one of the multiple electronic module interfaces of the processor circuit, wherein the enable signal input is configured to receive an enable signal from the processor circuit that indicates whether the electronic circuit is in an active operational mode or in an inactive operational mode, and
an internal control signal interface coupled to the first and second reconfigurable devices, wherein, after the controller circuit has received the encoded state information, and when the enable signal indicates that the electronic circuit has transitioned from the active operational mode into the inactive operational mode, the controller circuit is configured to send the encoded state information through the internal control signal interface to the first and second reconfigurable devices, wherein the encoded state information causes the first reconfigurable device to configure the first electronic component into a first-component state that corresponds to the selected circuit state, and causes the second reconfigurable device to configure the second electronic component into a second-component state that corresponds to the selected circuit state.

12. The electronic system of claim 11, wherein the active operational mode corresponds to a time interval during which the transmitter circuit is amplifying a signal to be transmitted, and the inactive operational mode corresponds to a time interval during which the transmitter circuit is not amplifying a signal to be transmitted.

13. The electronic system of claim 12, wherein:
each electronic module interface of the processor circuit further includes a receive signal input; and
each electronic module forms a portion of a transceiver that includes a receiver circuit coupled to the receive signal input of one of the electronic module interfaces of the processor circuit, the transceiver operates using time division duplexing, the active operational mode is established during first time intervals when the transmitter circuit is transmitting amplified signals and the receiver circuit is inactive, and the inactive operational mode is established during second time intervals when the transmitter circuit is inactive and the receiver circuit is receiving signals from an antenna.

14. The electronic system of any of claims 11 to 13, wherein the controller circuit further comprises:
a controller circuit data storage structure configured to store a first state table that includes first state data corresponding to a first circuit state of the multiple circuit states, and second state data corresponding to a second circuit state of the multiple circuit states, wherein
the first state data includes a first state index, a first component setting for the first electronic component, and a second component setting for the second electronic component, and
the second state data includes a second state index, a third component setting for the first electronic component, and a fourth component setting for the second electronic component.

15. A method of operating an electronic module, the method comprising:
receiving and processing a signal by an electronic circuit of the electronic module, wherein the electronic circuit includes
a first reconfigurable device that includes a first electronic component that is capable of being configured into any one of a first plurality of component states at any given time, and
a second reconfigurable device that includes a second electronic component that is capable of being configured into any one of a second plurality of component states at any given time;
receiving, by a controller circuit of the electronic module over an external control signal interface, encoded state information that indicates that the electronic circuit is to be configured into a selected circuit state of multiple circuit states;
receiving, by the controller circuit over an enable signal input, an enable signal that indicates whether the electronic circuit is in an active operational mode or in an inactive operational mode;
after the controller circuit has received the encoded state information, and when the enable signal indicates that the electronic circuit has transitioned from the active operational mode into the inactive operational mode, sending, by the controller circuit through an internal control signal interface, the encoded state information to the first and second reconfigurable devices;
configuring, by the first reconfigurable device in response to receiving the encoded state information, the first electronic component into a first-component state that corresponds to the selected circuit state; and
configuring, by the second reconfigurable device in response to receiving the encoded state information, the second electronic component into a second-component state that corresponds to the selected circuit state.
